# EUROPÄISCHE PATENTSCHRIFT

(11) **EP 2 553 687 B1**
(45) Veröffentlichungstag und Bekanntmachung des Hinweises auf die Patenterteilung: **10.06.2015**
(21) Anmeldenummer: 11715149.8
(22) Anmeldetag: 10.03.2011
(51) Int. Cl.: H01B 1/16, H01B 1/02, C23C 28/00, C23C 14/08, C23C 14/18, C23C 14/02, C23C 14/58, H01L 41/047, H01L 41/29, H03H 9/145

(54) **HOCHTEMPERATURBESTÄNDIGE, ELEKTRISCH LEITFÄHIGE DÜNNSCHICHTEN**
HIGH TEMPERATURE-RESISTANT, ELECTRICALLY CONDUCTIVE THIN FILMS
COUCHES MINCES ÉLECTROCONDUCTRICES RÉSISTANT AUX TEMPÉRATURES ÉLEVÉES

(30) Priorität: 29.03.2010 AT 5022010
(43) Veröffentlichungstag der Anmeldung: 06.02.2013
(73) Patentinhaber: CTR Carinthian Tech Research AG, 9524 Villach/St. Magdalen (AT); Vectron International GmbH, 14513 Teltow (DE)
(72) Erfinder: BARDONG, Jochen, A-9521 Treffen (AT); BRUCKNER, Gudrun, A-9241 Wernberg (AT); FACHBERGER, Rene, 4600 Wels (AT); WALL, Bert, 14469 Potsdam (DE)
(74) Vertreter: Beer & Partner Patentanwälte KG
(86) Internationale Anmeldenummer: PCT/AT2011/000124
(87) Internationale Veröffentlichungsnummer: WO 2011/120060

(56) Entgegenhaltungen:
- EP-A1- 0 306 270
- EP-A1- 2 100 988
- EP-A2- 0 246 626
- EP-A2- 1 458 030
- WO-A2-00/51233
- JP-A- 2010 066 723
- OKUMURA K ET AL: "Effect of nanostructures formed by oblique co-deposition on transient catalytic reactions", VACUUM, PERGAMON PRESS, GB, Bd. 84, Nr. 5, 10. Dezember 2009 (2009-12-10), Seiten 612-617, XP026790869, ISSN: 0042-207X [gefunden am 2009-06-13]
- H HABAZAKI: "The incorporation and mobility of chromium species in anodic alumina films", CORROSION SCIENCE, Bd. 39, Nr. 4, 1. April 1997 (1997-04-01), Seiten 719-730, XP55001355, ISSN: 0010-938X, DOI: 10.1016/S0010-938X(97)89338-9
- GOLAN G ET AL: "BILAYER STRUCTURE OF PD-AL2O3 FOR UV VIDICON APPLICATIONS", THIN SOLID FILMS, ELSEVIER-SEQUOIA S.A. LAUSANNE, CH, Bd. 283, Nr. 1/02, 1. September 1996 (1996-09-01), Seiten 235-238, XP000642777, ISSN: 0040-6090, DOI: 10.1016/0040-6090(96)08783-4
- F.G. GAUDETTE ET AL: INTERNATIONAL JOURNAL OF FRACTURE, Bd. 110, Nr. 4, 1. Januar 2001 (2001-01-01), Seiten 325-349, XP55007904, ISSN: 0376-9429, DOI: 10.1023/A:1010872200886
- A POGREBNJAK ET AL: "TiN/Cr/Al2O3 and TiN/Al2O3 hybrid coatings structure features and properties resulting from combined treatment", SURFACE AND COATINGS TECHNOLOGY, Bd. 201, Nr. 6, 10. Juli 2006 (2006-07-10) , Seiten 2621-2632, XP55007908, ISSN: 0257-8972, DOI: 10.1016/j.surfcoat.2006.05.018
- S TSUKIMOTO: "Texture of MBE grown Cr films on [alpha]-Al2O3(0001): the occurrence of Nishiyama-Wassermann (NW) and Kurdjumov-Sachs (KS) related orientation relationships", JOURNAL OF THE EUROPEAN CERAMIC SOCIETY, Bd. 23, Nr. 15, 1. Januar 2003 (2003-01-01), Seiten 2947-2954, XP55007946, ISSN: 0955-2219, DOI: 10.1016/S0955-2219(03)00306-6

## Beschreibung

Die Erfindung betrifft hochtemperaturbeständige, elektrisch leitfähige Dünnschichten beispielsweise in Form von Metallisierungen zur Realisierung von Kontaktierungen piezoelektrischer Bauteile, Verfahren zu deren Herstellung sowie Elemente umfassend die erfindungsgemäße Dünnschicht.

Eine Reihe technischer Anwendungen erfordert elektrisch leitfähige Metallisierungen mit Dauereinsatztemperaturen von 300°C und mehr, beispielsweise als Kontaktierungselemente oder Resistoren. Während dies im Allgemeinen in Form von Schichten aus thermisch beständigen Metallen oder elektrisch leitfähigen Verbindungen mit Schichtdicken ≥ 10 µm zuverlässig realisiert werden kann, sind derartig dicke Schichten, insbesonders im Mikro- und Nanostrukturbereich, oft nur eingeschränkt einsetzbar.

Entsprechende Anwendungen hoher technischer wie kommerzieller Relevanz sind beispielsweise Dünnschicht-Resistoren zur Messung physikalischer oder chemischer Parameter, oder auch piezoelektrische Systeme. So sind diverse Piezo-Materialien bekannt, und teilweise auch kommerziell erhältlich, die bis 1000°C und darüber stabil sind und ihre piezoelektrischen Eigenschaften behalten. Bei derartig hohen Temperaturen stellen allerdings die für die elektro-mechanische Kopplung erforderlichen Elektroden ein wesentliches technisches Problem dar, sobald - aus technischen oder sonstigen Gründen - die üblichen Dickschichtmetallisierungen nicht verwendet werden können. Hier fehlt bislang eine technisch zufriedenstellende rund kostengünstig realisierbare Lösung, was insbesonders für auf dem Prinzip akustischer Oberflächenwellen (AOFW, engl. surface acoustic waves, SAW) beruhende Bauteile ein wesentliches, die praktische Anwendbarkeit behinderndes Problem darstellt.

AOFW-Elemente haben sich z.B. in Frequenzfiltern wie auch in Sensoren zur Messung physikalischer (Temperatur, Druck, etc.) und/oder chemischer Parameter bewährt. Es sind zudem verschiedene Anwendungen bekannt in denen AOFW-Elemente, allein oder in Kombination mit einer Sensorfunktionalität, als funkauslesbare Identifikationsmarken (RFID-Marken) eingesetzt werden. Wesentliche Vorteile dieser Technologie sind, dass es möglich ist AOFW-Systeme vollständig passiv fernabzufragen, und dass sie im Prinzip über einen sehr breiten Temperaturbereich zuverlässig eingesetzt werden können. Damit haben derartige Sensor- bzw. RFID-Systeme wesentliche, technologische wie praktische Vorteile gegenüber herkömmlichen halbleiterbasierten Systemen. Aus der Literatur sind Tieftemperaturanwendungen bei -200°C ebenso bekannt wie Hochtemperaturanwendungen bei bis zu 1000°C. Entsprechende Anwendungen umfassen beispielsweise die Objektverfolgung von Schlackenpfannen, Gassensoren oder die Temperaturüberwachung sicherheitsrelevanter keramischer Bauteile in der Metallurgie.

Eine wesentliche Komponente in Design und Aufbau von AOFW-Elementen sind auf die Oberfläche des piezoelektrischen Substrats aufgebrachte Oberflächenstrukturen, insbesonders Interdigitalwandler und Reflektoren. Die dafür verwendeten Schichten haben üblicherweise Schichtdicken ≤ 1 µm, typischerweise 100 - 500 nm. Derartig geringe Schichtdicken erlauben es, an Oberflächenstrukturen vollständige wie partielle Reflektionen von Oberflächenwellen kontrolliert zu erzeugen, womit komplexe Strukturen wie beispielsweise reflektive Verzögerungsleitungen oder AOFW-Resonatoren erst realisierbar werden; die resultierenden AOFW-Elemente sind in Folge in Sensoren und/oder RFID-Marken besonders vorteilhaft einsetzbar. Zudem ermöglicht eine geringe Schichtdicke eine effiziente elektro-akustische Signalkopplung, und minimiert die mechanische Dämpfung der Oberflächenwellen bei Interaktion mit den Strukturen. Ein entscheidender Faktor ist dabei die Flächenbelastung, wodurch die Verwendung möglichst leichter Schichten, d.h. von Materialien geringer Dichte, Bedeutung erlangt.

Ein weiteres Schlüsselkriterium insbesonders für AOFW-Anwendungen ist die Möglichkeit, Dünnschichtmetallisierungen mit Strukturbreiten im Mikrometer- bis Sub-Mikrometerbereich, beispielsweise fingerförmig, präzise zu strukturieren. Die erforderlichen Strukturbreiten hängen dabei wesentlich von den verwendeten Betriebsfrequenzen ab; während die Strukturen auf AOFW-Elementen für eine Betriebsfrequenz von beispielsweise 433 MHz typischerweise Strukturbreiten von > 1 µm aufweisen, liegen die Strukturbreiten bei Auslegung für eine Betriebsfrequenz im oberen UHF-Bereich, beispielsweise bei 2,4 GHz, bei nur etwa 300 nm. In Kombination mit geringen Schichtdicken ergibt dies kleine Leitungsquerschnitte, was in Folge die Verwendung von Materialien mit guter elektrischer Leitfähigkeit bedingt.

Als abschließendes Kriterium ist aus technischen wie kommerziellen Gründen die Verwendung von Materialien vorteilhaft, die (i) kostengünstig verfügbar sind und (ii) mit Standardprozessen zur Dünnschichtabscheidung prozessiert werden können.

In Standardapplikationen bestehen die Oberflächenstrukturen von AOFW-Elementen vorzugsweise aus Aluminium, wie in EP-B1 0762641 oder Buff et al., Proc. 2003 IEEE Ultrason. Symp., p. 187-191 ausführlich dargelegt. Al-Metallisierungen sind leicht, elektrisch sehr gut leitfähig und exakt strukturierbar. Dünne Aluminiumschichten werden allerdings, trotz Schmelzpunkt bei 660°C, bereits ab etwa 300°C weich und anfällig insbesonders gegen Spannungsmigration. Zudem zeigt Al eine hohe chemische Affinität zu Sauerstoff und wird durch diesen zu elektrisch nicht leitfähigen Aluminiumoxiden oxidiert. Während sich diese Oxidation bei Temperaturen < 400°C auf eine oberflächliche Schicht mit typischerweise 5 - 10 nm Dicke beschränkt, und somit die Leitfähigkeit der Metallisierung erhalten bleibt, wächst die Oxidschicht bei höheren Temperaturen bis zu Dicken im Mikrometer-Bereich. Bei Dünnschichten kann dies unter Umständen zu einer vollständigen Oxidation der Metallisierung und somit einem Versagen des kontaktierten Elements führen.

Bezüglich der AOFW-Substrate existieren diverse technisch relevante Optionen. So erwähnt WO-A2 00/51233 allgemein, d.h. nicht spezifisch für Hochtemperaturanwendungen, die Möglichkeit der Verwendung unterschiedlicher Kristallschnitte von Langasit (La₃Ga₅SiO₁₄) bzw. Langanat (La₃Ga_{5.5}Ta_{0.5}O₁₄) ebenso wie den Einsatz von Quarz (SiO₂), Lithiumniobat (LiNbO₃) oder Lithiumtantalat (LiTaO₃). Da diese, wie die Mehrzahl der hochtemperaturbeständigen piezoelektrischen Substrate, Sauerstoff enthalten, und dieser bei Temperaturen von mehreren 100°C zumindest teilweise chemisch verfügbar wird, ist die Oxidation von Al-Strukturen in vielen Fällen auch durch ein Packaging in sauerstofffreier Atmosphäre nicht zu verhindern. Somit stellen Al-Schichten insgesamt keine geeignete Lösung zur Realisierung von elektrisch leitfähigen Dünnschicht-Metallisierungen für Hochtemperaturanwendungen dar.

Aus der Literatur ist eine Reihe alternativer Materialien zur Realisierung hochtemperaturbeständiger Dünnschichtmetallisierungen bekannt; eine entsprechende Zusammenstellung für AOFW-Elemente ist beispielsweise Hornsteiner et al., Proc. 1998 IEEE Freq. Control Symp., p. 615-620 oder US-B1 6,958,565 zu entnehmen. Häufig eingesetzte Materialien sind dabei insbesonders Platin und andere Metalle der Platingruppe des Periodensystems.

Obwohl Pt, ausgehend von dessen Schmelzpunkt von 1769°C, als Material gut für Hochtemperaturanwendungen geeignet ist und in verschiedenen Anwendungen eingesetzt wird, sind Pt-Schichten mit Schichtdicken ≤ 1µm nur bedingt temperaturbeständig. Insbesonders neigen Pt-Dünnschichten ab etwa 500°C zu Entnetzung und Inselbildung, was in der Praxis bereits nach kurzer Einsatzdauer zu einer Zersetzung der Strukturen führen kann. Neben dem Verlust der elektrischen Leitfähigkeit durch Zerstörung der Schichtkontinuität reduziert die Entnetzung auch die Kopplung der Schicht zum Substrat. Analoge Effekte sind auch bei anderen in Frage kommenden Metallen, wie beispielsweise Pd oder W, und auch bei Legierungen wie Pt+Rh oder Pt+Au, zu beobachten.

Bezüglich der Neigung zur Entnetzung gilt allgemein, dass der Effekt umso stärker ausgeprägt ist je dünner die Schicht bzw. schmäler die Strukturen sind. Stabile Schichten werden erst bei Schichtdicken und Strukturbreiten von jeweils zumindest einigen µm erhalten, was den oben gelisteten Anforderungen an die Oberflächenstrukturen auf AOFW-Elementen in mehreren Punkten zuwiderläuft. Dieses Problem wird in der Praxis dadurch weiter verstärkt, dass die für hochtemperaturbeständige Metallisierungen in Frage kommenden Materialien durchwegs eine signifikant höhere Dichte als Aluminium haben. Um die Flächenbelastung, und somit die Dämpfung und die Kopplungseffizienz, näherungsweise konstant zu halten, sind hier dünne Schichten zwingend erforderlich.

Zur Vermeidung von Entnetzungseffekten wird in der Fachliteratur zunächst die Verwendung von Haftschichten, beispielsweise aus Ti oder Zr vorgeschlagen, die in der Regel gleichzeitig auch als Diffusionsbarriere zwischen Substrat und Haftschicht fungieren (Hornsteiner et al., Phys. Status Solidi A, 163, p. R3-R4; Buff et al., Proc. 2003 IEEE Ultrason. Symp., p. 187-191; Thiele & da Cunha, Electron. Lett. 39(10), p. 818-819; US-B1 7,285,894, etc.). Ebenso wurde der Einsatz, zumeist oxidischer, Deck- und Passivierungsschichten, beispielsweise aus SiO₂ oder Silizium-Alurninium-Oxynitriden (SiAlON) vorgeschlagen.

In der Praxis können damit Entnetzungen und sonstige temperaturbedingte Alterungseffekte zwar reduziert, aber nicht dauerhaft zuverlässig verhindert werden. Als Abhilfe wurden, beispielsweise in WO-A2 2009/035797, da Cunha et al., Proc. 2007 IEEE Ultrason. Symp., p. 2107-2110, sowie diversen verwandten Publikationen, aus (i) hochschmelzenden Metallen, insbesonders Pt, Rh oder Pt+Rh-, Pt+Ir- oder Pt+Au-Legierungen und (ii) Zirkoniumdioxid (ZrO₂) bestehende Schichten vorgeschlagen.

Derartige Metall/ZrO₂-Schichten mit typischen Gesamtdicken von 100 - 150 nm gelten als derzeit technisch bester Ansatz zur Realisierung von Dünnschichtkontaktierungen für Hochtemperaturanwendungen. Das ZrO₂ wirkt dabei als die Metallschicht stabilisierende und dadurch Entnetzung und Inselbildung verhindernde Komponente. Als Haftschicht und Diffusionsbarriere werden vorzugsweise dünne Zr-Schichten verwendet; optional kann die Schicht zudem mit einer Passivierungsschicht, insbesonders aus SiAlON, geschützt werden. Damit wird die Applikation entsprechender Dünnschichtelektroden bis zu Temperaturen von 1000°C möglich. Nichtsdestotrotz hat diese Lösung im praktischen Einsatz verschiedene, die Anwendbarkeit und kommerzielle Konkurrenzfähigkeit wesentlich beeinträchtigende Nachteile.

ZrO₂ zeigt gemäß Literatur eine äußerst geringe Neigung zur Vermischung mit allen gebräuchlichen hochtemperaturbeständigen Leitmetallen (vgl. WO-A2 2009/035797 [0062] und [0095]). Zur Realisierung einer stabilen, elektrisch durchgehend leitfähigen homogenen Schicht ist es in solchen Systemen somit erforderlich, die Leitschicht aus einer Vielzahl sehr dünner Schichten aufzubauen, die schichtdurchdringend miteinander in Kontakt sehen. Bei Abscheidung höherer Schichtdicken würden die Oxidschichten als Isolatorschichten zwischen den Leitschichten fungieren, was die Leitfähigkeit wie auch die Hochfrequenzeigenschaften der Schichten beeinträchtigen würde. Analog dazu besteht bei Verwendung dickerer Leitmetallschichten - bedingt durch die essentiell zweidimensionale Form der oxidischen Stützschichten - die Gefahr von Entnetzungen.

In der vorbekannten Praxis wird dies durch abwechselnde Abscheidung von multiplen, jeweils eng tolerierten Dünn(st)schichten (typischen Schichtdicken von jeweils 0,5 - 5 nm) des Leitmetalls und von Zr bzw. ZrO₂ erreicht, oder mittels Co-Abscheidung von Leitmetall und Zr in einer sauerstoffhältigen Reaktivgasatmosphäre. Beides ist mit einem hohen Herstellungsaufvvand verbunden.

Ein zweiter relevanter Nachteil ist, dass Zr bzw. ZrO₂, wie auch verschiedene in Kombination damit verwendete Leitmetalle, z.B. Rh, nicht zu den in der Dünnschichtabscheidung gebräuchlichen Standard-Materialien zählen. Gemeinsam mit den hohen Anforderungen zur gleichmäßigen, reproduzierbaren Abscheidung dünnster Schichten resultieren daraus hohe Herstellungskosten, die einer breiten Verwendung derartig aufgebauter AOFW-Elemente in kommerziellen Anwendungen im Weg stehen.

Ein vergleichbarer Ansatz mit einem gebräuchlicheren oxidischen Material ist aus der chemischen Gas-Sensorik in Form von gesputtertem Al₂O₃ in katalytisch aktive Pt-Al₂O₃-Dünnschichten bekannt (Okumura und Motohiro, Vacuum 84(5), p. 612-617). Das Aluminiumoxid hat dabei die Aufgabe, die einige 100 nm dicke Dünnschicht zu strukturieren und zu stabilisieren, wobei der Schwerpunkt auf Optimierung der katalytischen Aktivität der resultierenden Schichten liegt. Alternativ zur gleichzeitigen Sputter-Abscheidung von Metall und Al₂O₃ können hier auch durch alternative Verfahren zum Einsatz kommen. So beschreiben beispielsweise Habazaki et al., Corrosion Science 39(4), p. 719-730 die Herstellung von Aluminiumoxid/Chrom-Schichten für mechanistischen Studien zur Einlagerung und Mobilität von Chrom-Ionen in Aluminiumoxid-Schichten, wobei Al und Cr gemeinsam auf ein Substrat abgeschieden und das Al in Folge durch selektive anodische Oxidation zu Al₂O₃ umgewandelt wird.

Die entsprechenden Literaturstellen enthalten keine Informationen zur elektrischen Leitfähigkeit dieser Schichten oder zur Nutzung derartiger Schichten als elektrische Leitschichten. Wie in der Einleitung erwähnt stellt eine gute elektrische Leitfähigkeit allerdings eine essentielle Voraussetzung für die praktische Verwendung derartiger Schichten als elektrisch leitfähige Dünnschichten dar.

Der damit zusammenhängende dritte wesentliche Nachteil vorbekannter Ansätze ergibt sich aus den typischen Materialeigenschaften der vorbekannten Schichtstrukturen. Pt hat eine deutlich schlechtere Leitfähigkeit als z.B. Al, was zur Einhaltung eines zulässigen Widerstandswerts entsprechend große Leiterquerschnitte erforderlich macht. Da die Schichtdicke durch die hohe Dichte des Pt-Metalls limitiert ist, erfordert dies Strukturbreiten von typischerweise ≥ 1 µm. Damit sind Pt- bzw. Pt/ZrO₂-Strukturen auf Betriebsfrequenzen < 1 GHz beschränkt, was die Auswahl und Messempfindlichkeit derartiger Systeme stark einschränkt.

Die als Abhilfe vorgeschlagene Verwendung von Rh als Leitmetall verbessert zwar, in Folge der geringeren Dichte und besseren elektrischen Leitfähigkeit im Vergleich zu Pt, die technische Ausgangssituation, ist allerdings bedingt durch die hohen Produktions- und Materialkosten insbesonders von Rh-Schichten eine nur für Spezialanwendungen z.B. im militärischen Bereich praktikable Lösung.

Insgesamt existiert somit bislang keine technisch zufriedenstellende Lösung zur Herstellung von hochtemperaturbeständigen, elektrisch gut leitfähigen Dünnschichtstrukturen im Allgemeinen und UHF-geeigneten AOFW-Metallisierungen im Besonderen, die kostengünstig herstellbar und damit gegen alternative Technologien konkurrenzfähig sind.

Hier will die Erfindung Abhilfe schaffen.

Erfindungsgemäß werden daher hochtemperatur-beständige, elektrisch leitfähige Dünnschichten bestehend aus zwei komplementären Komponenten, nämlich einem elektrisch leitfähigem Material (Leitmetall) mit einem Schmelzpunkt > 1500 °C und einer Alreichen nicht-stöchiometrischen Aluminiumoxid-Komponente ("Al₂O₃+Al") als Strukturgeber für das Leitmetall, vorgeschlagen. Bei dem Leitmetall kann es sich um einzelne metallische Elemente oder Legierungen dieser Elemente handeln. Voraussetzung für die Auswahl als Leitmetall ist ein Schmelzpunkt von > 1500°C. Die Al-reichen Aluminiumoxidkomponenten, die äquivalent als Al-reiche nicht-stöchiometrische Formen von Aluminiumoxiden oder als Mischungen aus stöchiometrischem Aluminium(III)oxid und metallischem Aluminium betrachtet werden können, fungieren in Folge gleichzeitig als Strukturkomponente und Legierungselement. Dabei ist wesentlich, dass freies, chemisch verfügbares Al aus der Al₂O₃+Al-Komponente mit dem Metall der Leitschicht legiert, wodurch wesentliche Eigenschaften der Schicht, insbesonders die elektrische Leitfähigkeit, durch das Al/Leitmetall-Verhältnis kontrolliert beeinflusst werden können.

Als Dünnschicht bzw. Leitschicht bezeichnet man das Komplementärsystem umfassend die Komponenten Leitmetall und Aluminiumoxidkomponente.

Anders als in vorbekannten Systemen vermischen sich Aluminium und Aluminiumoxide unter Temperatureinfluss gut und homogen mit den Leitmetallen, was in den erfindungsgemäßen Schichten gezielt genutzt wird, um den Herstellaufwand zu reduzieren und die Schichtstabilität zu verbessern.

Zudem können die erfindungsgemäß verwendeten Aluminiumoxide auch als Haftschichten, Diffusionsbarrieren und/oder Passivierungsschichten verwendet werden.

Der erfindungsgemäße Schichtaufbau ermöglicht damit, hochtemperaturbeständige Dünnschichtmetallisierungen mit vergleichsweise niedriger Dichte und guter elektrischer Leitfähigkeit kostengünstig unter Verwendung von allgemein gebräuchlichen, weit verbreiteten Prozessen und Materialien der Dünnschichtabscheidungen in Standardanlagen zu realisieren.

Der Aufbau der erfindungsgemäßen Schichten wird anhand nachfolgender schematischer Zeichnungen erläutert.

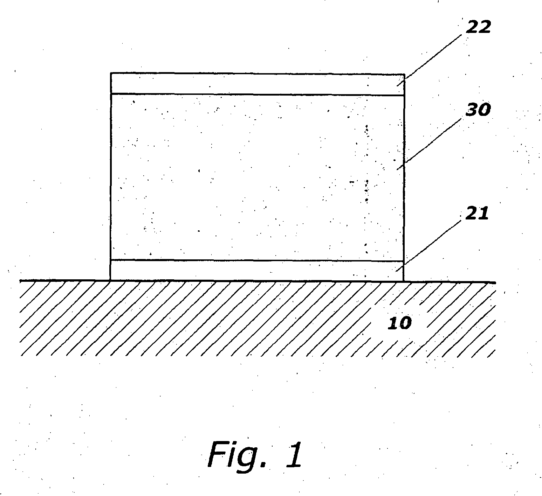

Fig. 1 zeigt eine erfindungsgemäße hochtemperaturbeständige Metall|Al₂O₃+Al-Dünnschicht in einer sandwichartigen Ausführungsform, mit einer Haftschicht/Diffusionsbarriere (21) zwischen Substrat (10) und Metallisierung, einer Deckschicht (22), und einer zwischen diesen Schichten eingebetteten Leitschicht (30), in einem Querschnitt durch die Schicht.

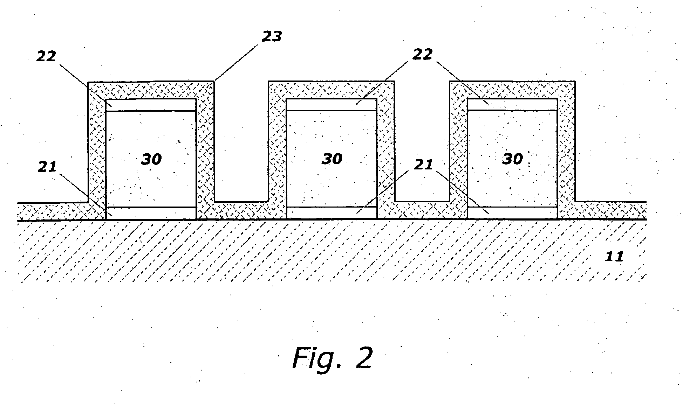

Fig. 2 zeigt eine prinzipielle Anordnung zur Realisierung eines AOFW-Elements unter Verwendung einer erfindungsgemäßen, lateral strukturierten Dünnschichtmetallisierung auf einem piezoelektrischen AOFW-Substrat (11) in Kombination mit einer zusätzlichen, durchgängigen Passivierungsschicht (23), in einem Querschnitt durch einen Teil einer typischen AOFW-Oberflächenstruktur.

Die erfindungsgemäßen Schichtstrukturen bestehen prinzipiell aus zwei, komplementäre Funktionen erfüllenden Komponenten, (i) einem hochtemperaturbeständigen Leitmetall, und (ii) einer Strukturkomponente auf Basis eines Al-reichen Aluminiumoxids-.

Das hochtemperaturbeständige Leitmetall, das mit ≥ 50%(v/v) die vorherrschende Komponente der Mischschicht darstellt, dient als Grundmaterial und Leitschicht für den elektrischen Strom. Zur Realisierung kommen eine Reihe unterschiedlicher Materialien mit geeignetem Verhalten, insbesonders einem für die Anwendung ausreichend hohem Schmelzpunkt > 1500°C, entsprechenden thermisch-mechanischen Eigenschaften und Oxidationsbeständigkeit auch bei hohen Temperaturen, in Frage.

Ein besonders vorzugsweise verwendetes Schichtmaterial ist Platin, das einen hohen Schmelzpunkt aber auch eine hohe Dichte und begrenzte elektrische Leitfähigkeit besitzt.

Um den elektrischen Leitwert und die Dichte, aber auch das thermische Verhalten (Schmelzpunkt, etc.) der vorgeschlagenen Dünnschichtmetallisierungen auf die jeweilige Anwendung anzupassen, ist es möglich und für bestimmte Anwendungen vorteilhaft, Pt zumindest teilweise, gegebenenfalls auch vollständig, durch andere hochschmelzende Metalle zu substituieren. Dabei gilt die Grundregel, dass die Eigenschaften der finalen Dünnschicht den Bulkeigenschaften des Substituts folgen; so haben etwa Pd oder Rh eine geringere Dichte als Pt, was beispielsweise für das Design von AOFW-Elementen für hohe Betriebsfrequenzen vorteilhaft ist. Entsprechend ist die Anpassung der Schichteigenschaften durch Substitution des Pt durch, oder Legierung mit zumindest einem der Elemente Pd, Mo, Cr, Ti, Ta, W, Ir und/oder Rh möglich.

Die Al-reiche Aluminiumoxid-Komponente der erfindungsgemäßen Schichten bildet bei erhöhten Temperaturen, üblicherweise in einem Temperschritt, innerhalb weniger Stunden eine die gesamte Metallisierung dreidimensional durchdringende, stabile Struktur aus. Diese bewirkt in Folge eine Stabilisierung der metallischen Leitschicht gegen Inselbildung und Entnetzung. Dabei ist es wesentlich, dass sich Aluminium bzw. Aluminiumoxide, anders als z.B. ZrO₂, bei erhöhten Temperaturen gut mit den verwendeten Leitmetallen vermischen. Dies bewirkt eine Reihe praktischer Vorteile.

Zunächst ermöglicht die Durchmischungsneigung der erfindungsgemäßen Komponenten, die beiden Schichtbestandteile in Form vergleichsweise weniger, entsprechend dickerer Materialschichten schichtweise aufzubringen, ohne dass sich isolierende Oxiddomänen oder entnetzungsgefährdete Metalldomänen bilden. Dies reduziert den Herstellaufwand gegenüber vorbekannten Systemen beträchtlich.

Weitere Vorteile sind, dass (i) Al, anders als Zr, ein in der Dünnschichtabscheidung gebräuchliches Material ist, und (ii) dass Al₂O₃ eine um etwa 30% geringere Dichte als ZrO₂ aufweist, womit Schichten mit entsprechend geringerer Flächenbelastung oder, bei gleicher Flächenbelastung, etwas größerem Querschnitt und somit geringerem Widerstand realisierbar sind.

Bei der erfindungsgemäß vorgeschlagenen Verwendung Al-reicher, nicht-stöchiometrischer Aluminiumoxide bewirkt die Al₂O₃+Al-Komponente, zusätzlich zur beschriebenen Funktion als dreidimensionale Strukturkomponente, bei erhöhten Temperaturen eine Legierung der hochtemperaturbeständigen Leitmetalle mit Al. Anders als bei vorbekannten Systemen ermöglicht die Verwendung eines mit dem Leitmaterial legierenden Bestandteils, die Schichteigenschaften durch geeignete Wahl des Verhältnisses Leitmetall / metallisches Aluminium gezielt zu beeinflussen und an die Anwendung anzupassen. Dieser, auch elementaranalytisch nachgewiesene, Vorgang beeinflusst insbesonders die elektrischen Eigenschaften der Leitschicht; durch den guten elektrischen Leitwert des Aluminiums steigt die elektrische Leitfähigkeit der Schicht. Parallel dazu können auch thermisch-mechanische Eigenschaften, wie Massendichte und Sprödigkeit, beeinflusst werden.

Zudem fungiert metallisches Al durch seine hohe Affinität zu Sauerstoff als die Oxidation des, Leitmetalls inhibierender Sauerstofffänger. TEM-Untersuchungen zeigen, dass oberflächennahes Al an die Oberfläche wandert und dort eine fest haftende, dünne oxidische Passivschicht bildet; parallel dazu wirkt im Schichtinneren verbleibendes Al vor Ort als Oxidationsinhibitor. Dabei wirken die beiden metallischen Bestandteile symbiotisch: das Leitmetall minimiert, gemeinsam mit der oberflächlichen Oxidschicht, den Sauerstoffeintrag und verhindert dadurch die vollständige Oxidation von Al auch bei hohen Temperaturen, und das legierte Al bindet verbleibenden Sauerstoff als Aluminiumoxid, welches in Folge die Strukturkomponente verstärkt.

Aluminiumoxid-Schichten, wahlweise auf Basis Al₂O₃+Al oder stöchiometrischem Al₂O₃, können zudem auch als Haftschicht zwischen Substrat und Metallisierung, als Diffusionsbarriere zur Vermeidung einer Umstrukturierung der Schicht bzw. einer Veränderung der Zusammensetzung der Oberfläche des Substrats durch direkten Kontakt bei hohen Temperaturen, zur Substratpassivierung und/oder als passivierende Deckschicht auf der Dünnschichtmetallisierung verwendet werden.

Das Resultat sind hochtemperaturbeständige, mit Hilfe von Standard-Prozessen zur Dünnschichtabscheidung auch lateral strukturiert realisierbare Schichten mit, im Vergleich zu klassischen Pt- bzw. Pt|ZrO₂-Schichten, besserer Leitfähigkeit und geringerer Dichte. Dies ermöglicht, kompakte Strukturen mit vergleichsweise geringer Flächenbelastung zu realisieren. Insgesamt betrachtet bewirkt die erfindungsgemäße Schichtzusammensetzung damit eine Reihe technischer wie ökonomischer Vorteile:

Die verwendeten Ausgangsmaterialien sind allgemein gebräuchlich und zuverlässig prozessierbar, und es ist, anders als in vorbekannten Systemen, nicht erforderlich ultradünne Schichtlagen mit Schichtdicken < 5 nm hochpräzise abzuscheiden.

Haftschichten, Diffusionsbarrieren und/oder passivierende Deckschichten bestehen vorzugsweise aus dem selben Material wie die Strukturkomponente der Leitschicht, und sind somit ohne Zusatzaufwand in den Herstellprozess integrierbar.

Bedingt durch diese Faktoren sind die erfindungsgemäßen Schichten vergleichsweise kostengünstig herstellbar und damit besser gegen Alternativtechnologien konkurrenzfähig als vorbekannte Systeme.

Aus technischer Sicht ermöglicht die niedrigere Dichte bei gleicher Flächenbelastung eine Realisierung dickerer Leitschichten, wodurch die erzielbare thermische Stabilität weiter verbessert werden kann.

Gleichzeitig ermöglicht die ebenfalls verbesserte elektrische Leitfähigkeit, Ausführungen mit geringeren Leitungsbahnquerschnitten und somit schmalere Strukturen zu realisieren. Die ist für AOFW-Anwendungen allgemein von Interesse, insbesonders aber für solche mit höheren Betriebsfrequenzen von Vorteil.

Die erfindungsgemäßen Leitschichten können je nach Anwendung auf unterschiedliche, piezoelektrische wie inerte Substrate aufgebracht werden. Beispielsweise sind für Hochtemperaturanwendungen von AOFW-Systemen mit Dauergebrauchstemperaturen > 300°C Substratmaterialien (i) aus der LGX-Familie (Langasit La₃Ga₅SiO₁₄, Langanit La₃Ga_{5.5}Nb_{0.5}O₁₄ und Langanat La₃Ga_{5.5}Ta_{0.5}O₁₄, sowie deren Substitutionsisomorphe, wie z.B. La₃Ga_{5.25}Ta_{0.25}Si_{0.5}O₁₄ oder La₃Ga₅Zr_{0.5}Si_{0.5}O₁₄), (ii) dazu strukturisomorphe Verbindungen der allgemeinen Zusammensetzung A₃BC₃Si₂O₁₄, wie beispielsweise Sr₃TaGa₃Si₂O₁₄, Sr₃NbGa₃Si₂O₁₄, Ca₃TaGa₃Si₂O₁₄ oder Ca₃TaAl₃Si₂O₁₄, (iii) auf ein nicht-piezoelektrisches Substrat aufgewachsene piezoelektrische Metallnitridschichten mit III-V-Verbindungshalbleitercharakter, insbesonders AlN und GaN, (iv) Lanthanoid-Calcium-Oxyborate, insbesonders GdCa₄O(BO₃)₃, YCa₄O(BO₃)₃ und LaCa₄O(BO₃)₃, (v) Lithiumniobate (LiNbOₓ, x=3) und (vi) Gallium-Orthophosphat (GaPO₄) von besonderem Interesse.

Die Schichtaufbringung kann auf verschiedene Arten erfolgen, wobei die relativen Anteile der einzelnen Komponenten je nach Anwendung auch variiert werden können. Besonders vorzugsweise Verfahren zur Schichtaufbringung sind (i) die Aufbringung in Form alternierender Einzelschichten des Leitmetalls und der Al-reichen Aluminiumoxid-Komponente(n), sowie (ii) eine Aufbringung als homogene Mischschicht aus Leitmetall und Al-reichem Aluminiumoxid-.

Im ersten vorzugsweisen Herstellungsverfahren wird die resultierende Schicht in Form mehrerer (Anzahl n) alternierender Lagen des Leitmetalls und von Al₂O₃+Al aufgebracht. Das Verhältnis der Schichtdicken des Leitmetalls und des Al-reichen Aluminiumoxids Al₂O₃+Al liegt dabei typischerweise im Bereich 4:1 bis 3:2. Die Aufbringung der, typischerweise jeweils 5 - 20 nm dicken Schichten, kann dabei durch beliebige, dem Fachmann hinlänglich bekannte PVD- und/oder CVD-Verfahren erfolgen. Al-reiche Aluminiumoxid-Schichten werden vorzugsweise durch Aufdampfen oder Sputtern von Al in einer kontrollierten, sauerstoffhältigen Reaktivgasatmosphäre hergestellt; der Sauerstoffgehalt im Reaktivgas ermöglicht dabei, den Grad der Oxidation des Al zu Al₂O₃+Al zu regeln und dadurch, gemeinsam mit der Wahl der relativen Schichtdicken, die Schichteigenschaften gezielt zu beeinflussen.

Die Dicke der Gesamtschicht ist über die Schichtdicken der Einzellagen und die Anzahl n der Doppelschichten Leitmetall/Al₂O₃+Al kontrollierbar. Für AOFW-Elemente liegt die Gesamtschichtdicke typischerweise bei 50 - 200 nm; für andere Applikationen sind auch andere, insbesonders höhere Schichtdicken realisierbar.

Durch die getrennte Abscheidung von Leitmetall und Al-reichem Aluminiumoxid ist dieses Verfahren besonders gut für Leitmetalle geeignet, die oxidationsempfindlich sind oder aus anderen Gründen nicht gleichzeitig mit der, unter oxidierenden Bedingungen stattfindenden, Al-Abscheidung auf das Substrat aufgebracht werden können.

Weiters ermöglicht eine lagenweise Schichtaufbringung eine Realisierung von Schichten mit über die Schichtstärke variabler Schichtzusammensetzung. Dabei kann wahlweise das Verhältnis Leitmetall zu Al-reichem Aluminiumoxid, das Verhältnis Al zu Al₂O₃ in der Al₂O₃+Al-Komponente und/oder die Zusammensetzung des Leitmetalls in Abhängigkeit der Position im Schichtstapel variiert werden. Damit ist es beispielsweise möglich, durch entsprechende Variation der Abscheidebedingungen einen höher mit Al-legierten und somit besser leitfähigen Schichtkern mit einer stärker oxidischen, strukturerhaltenden und passivierenden Hüllschicht zu umgeben.

In einem zweiten vorzugsweisen Herstellverfahren werden das Leitmetall und Al-reiche Aluminiumoxide simultan als homogene Schicht abgeschieden. Dies kann beispielsweise durch gleichzeitiges Verdampfen oder Sputtern mit jeweils mehreren Quellen, oder auch einer einzelnen Quelle mit entsprechender Zusammensetzung zweier oder mehrere Metalle, in einer sauerstoffhältigen Reaktivatmosphäre erfolgen.

Dieses Verfahren zeichnet sich durch einen geringen Produktionsaufwand und optimale Schichthomogenitäten aus, ist aber beschränkt auf Leitmetallmaterialien mit geringer Sauerstoffaffinität, insbesonders Platin-Elemente.

Unabhängig von der gewählten Art der Abscheidung verändert sich die Schicht bei Erwärmung auf Temperaturen über etwa 500°C.

Freies Al legiert teilweise mit dem Leitmetall und beeinflusst dadurch die Schichteigenschaften, insbesonders die elektrische Leitfähigkeit, teilweise diffundiert es an die Oberfläche und bildet dort mit Sauerstoff aus der umgebenden (Schutzgas-) Atmosphäre oder dem Substratmaterial eine Passivschicht. Dadurch verbessert sich die Temperaturstabilität der Schicht.

Bei lagenweise abgeschiedenen Schichten bewirkt eine Erwärmung auf Temperaturen über etwa 500°C zudem die besprochene Durchmischung der einzelnen Schichten; in Folge dieser entsteht eine weitgehend homogene Leitschicht (30). Elektronenmikroskopische Aufnahmen der Schichtquerschnitte nach Temperaturbehandlung zeigen derartige homogene Leitschichten, entsprechend Schicht 30 in Fig. 1, auch bei schichtweiser Aufbringung. gemäß dem ersten genannten vorzugsweisen Verfahren der Schichtaufbringung.

Die Veränderung der Schichten bei hohen Temperaturen bewirkt eine Veränderung der Schichteigenschaften innerhalb der ersten Stunden unter Temperaturbelastung. Dieser sogenannte Burn-In Effekt kann im Einsatz zu Veränderungen der Signale über die Zeit bzw. zu Interferenzen führen. Aus diesem Grund ist es für viele Anwendungen vorteilhaft, die abgeschiedenen Schichten vor dem Einsatz einem eigenen Temperschritt bei typischerweise ≥ 600°C zu unterziehen. Alternativ ist es auch möglich, diese Temperung im Einsatz durchzuführen, und die daraus resultierenden Signalveränderungen entweder in Kauf zu nehmen, oder in geeigneter Art und Weise, beispielsweise über entsprechende Auswertealgorithmen, zu kompensieren.

Bei beiden vorzugsweisen Herstellverfahren ist es in der Regel sinnvoll, vor Abscheidung der Leitschicht zur Vermeidung eines Stoffaustauschs zwischen Substrat und Leitschicht eine Diffusionsbarriere auf das Substrat aufzubringen, die gleichzeitig auch als Haftschicht dient. Die optimale Dicke der Haftschicht/Diffusionsbarriere (21) richtet sich dabei nach den Anforderungen und den verwendeten Materialien; übliche Schichtstärken oder Haftschicht/Diffusionsbarriere liegen im Bereich 5 - 30 nm. Die Schicht sollte gleichzeitig möglichst dünn sein, um die Gesamthöhe und somit die Flächenbelastung der Dünnschichtmetallisierung gering zu halten, und dick genug um auch nach einer temperaturbedingten Durchmischung des Schichtstapels noch als zuverlässige Diffusionsbarriere zu fungieren. Insbesonders bei Verwendung von sonst chemisch inkompatiblen Leitschicht/Substrat-Paarungen ist es dazu oft nötig, die Haftschicht/Diffusionsbarriere dicker auszuführen.

Zur Verbesserung der thermischen Beständigkeit kann es auch sinnvoll sein, die Leitschicht mit einer eigenen, passivierenden Deckschicht (22) zu bedecken (Fig. 2). Auch hier ist es oft sinnvoll die Schicht vergleichsweise dick auszuführen, um die Schichtintegrität der Deckschicht auch über die Durchmischung hohen Temperaturen hinweg sicher zu stellen.

Um die Hochtemperatur-Stabilität der Schicht sowie des Substrates noch weiter zu verbessern, ist es oft vorteilhaft, die Dünnschichtmetallisierung und das Substrat (10, 11) mit einer durchgehenden, temperaturstabilen, nichtleitenden Passivierungsschicht (23), wie in Fig. 2 am Beispiel eines, die erfindungsgemäße Metallisierungen verwendenden AOFW-Elements gezeigt, zu überziehen; typische Schichtdicken dieser Passivierungen liegen im Bereich 5 - 30 nm.

Analog dazu kann es auch sinnvoll sein, das Substrat mit einer durchgehenden, temperaturstabilen, nichtleitenden Substratpassivierungsschicht zu versehen.

Besonders effizient ist es, für diese zusätzlichen Schichten, d.h. Haftschichten/Diffusions-barrieren (21), Deckschichten (22) und Passivierungsschichten (23) die selben Materialien wie für die Strukturkomponente der Leitschicht zu verwenden, d.h. Al₂O₃ oder Al₂O₃+Al. Alternativ ist es gleichwertig auch möglich, andere geeignete Materialien, wie z.B. SiO₂, ZrO₂ oder SiAlON als Haftschicht, Diffusionsbarriere, Substratpassivierung und/oder passivierende Deckschicht zu verwenden.

## Patentansprüche

1. Hochtemperaturbeständige, für den Einsatz bei erhöhten Temperaturen von mehr als 300°C geeignete, elektrisch leitfähige Dünnschicht mit einer Dicke von ≤ 1 µm zur Aufbringung auf ein festes Substrat, **dadurch gekennzeichnet, dass** die Dünnschicht aus einer Mischung zweier komplementärer Komponenten, einem elektrisch leitfähigen Material (Leitmetall) mit einem Schmelzpunkt > 1500°C und einer Aluminiumoxid-Komponente aus aluminium-reichen Aluminiumoxiden in Form von aluminium-reichen nicht-stöchiometrischen Oxiden bzw. Aluminium(III)oxid/Aluminium-Mischungen als Strukturgeber für das Leitmetall besteht.

2. Hochtemperaturbeständige, elektrisch leitfähige Dünnschicht nach Anspruch 1, **dadurch gekennzeichnet, dass** das Leitmetall aus Platin, Palladium, Molybdän, Chrom, Titan, Tantal, Wolfram, Iridium, Rhodium, oder Legierungen dieser Elemente besteht.

3. Hochtemperaturbeständige, elektrisch leitfähige Dünnschicht nach Anspruch 2, **dadurch gekennzeichnet, dass** der Anteil des Leitmetalls an der gesamten Dünnschicht bei zumindest 50%(v/v), vorzugsweise bei 60%(v/v) bis 80%(v/v) liegt.

4. Verfahren zur Herstellung temperaturbeständiger, elektrisch leitfähiger Dünnschichten nach einem der Ansprüche 1 bis 3, **dadurch gekennzeichnet, dass** das Leitmetall und die Aluminiumoxid-Komponente abwechselnd in Form dünner, vorzugsweise jeweils 5 nm bis 20 nm dicker, Leitmetall- und Aluminiumoxid-Schichten entsprechender Zusammensetzung, bis zum Erreichen der gewünschten Schichtdicke ≤ 1 µm auf eine Oberfläche aufgetragen werden, und dass diese abgeschiedenen Schichten vor dem Einsatz einem mehrstündigen Temperschritt bei typischerweise 600°C oder mehr unterzogen werden, wodurch sich die einzelnen Schichten vermischen, sodass eine Mischung aus Aluminiumoxid-Komponente und Leitmetall gebildet wird.

5. Verfahren zur Herstellung temperaturbeständiger, elektrisch leitfähiger Dünnschichten nach einem der Ansprüche 1 bis 3, **dadurch gekennzeichnet, dass** das Leitmetall und die Aluminiumoxid-Komponente gleichzeitig, insbesonders durch gleichzeitiges Aufdampfen oder Sputtern des Leitmetalls und des metallischen Aluminiums in einer oxidierenden Reaktivgasatmosphäre, auf eine Oberfläche aufgetragen werden.

6. Verfahren zur Herstellung temperaturbeständiger, elektrisch leitfähiger Dünnschichten nach Anspruch 4 oder 5, **dadurch gekennzeichnet, dass** - vor und/oder nach der Abscheidung der elektrisch leitfähigen Dünnschicht - zusätzlich Haftschichten, Diffusionsbarrieren und/oder Deckschichten auf das Substrat und/oder die elektrisch leitfähige(n) Dünnschicht(en) aufgetragen werden.

7. Hochtemperaturbeständiges Element umfassend ein Substrat sowie eine darauf aufgebrachte elektrisch leitfähige Dünnschicht nach einem der Ansprüche 1 bis 3.

8. Hochtemperaturbeständiges Element nach Anspruch 7, **dadurch gekennzeichnet, dass** eine Haftschicht und/oder Diffusionsbarriere, vorzugsweise auf Aluminiumoxid-Basis, zwischen dem Substrat und der elektrisch leitfähigen Dünnschicht vorliegt.

9. Hochtemperaturbeständiges Element nach Anspruch 7 oder 8, **dadurch gekennzeichnet, dass** zumindest eine, die elektrisch leitfähige Dünnschicht und/oder das Substrat bedeckende, passivierende Deckschicht, vorzugsweise auf AluminiumoxidBasis, vorliegt.

10. Akustische Oberflächenwellen (AOFW)-Elemente, insbesonders für den Einsatz bei erhöhten Temperaturen von 300°C und mehr, umfassend ein piezoelektrisches Substrat und eine darauf aufgebrachte elektrisch leitfähige Dünnschicht, nach einem der Ansprüche 1 bis 3.

11. AOFW-Elemente nach Anspruch 10, insbesonders für den Einsatz bei erhöhten Temperaturen von 300°C und mehr, **dadurch gekennzeichnet, dass** das piezoelektrische Substrat ausgewählt aus der Gruppe:
- thermisch stabile Materialien aus der LGX-Familie, insbesondere Langasit (La₃Ga₅SiO₁₄), Langanit (La₃Ga_{5.5}Nb_{0.5}O₁₄) oder Langanat (La₃Ga_{5.5}Ta_{0.5}O₁₄), oder deren Substitutionsisomorphe, wie beispielswiese La₃Ga_{5.25}Ta_{0.25}Si_{0.5}O₁₄ oder La₃Ga₅Zr_{0.5}Si_{0.5}O₁₄, oder
- dazu strukturisomorphen Verbindungen der allgemeinen Zusammensetzung A₃BC₃Si₂O₁₄, wie beispielsweise Sr₃TaGa₃Si₂O₁₄, Sr₃NbGa₃Si₂O₁₄, Ca₃TaGa₃Si₂O₁₄ oder Ca₃TaAl₃Si₂O₁₄, oder
- Lanthanoid-Calciurn-Oxyborate, insbesonders GdCa₄O(BO₃)₃, YCa₄O(BO₃)₃ oder LaCa₄O(BO₃)₃, oder
- Lithiumniobate (LiNbOₓ, x≈3), oder
- Gallium-Orthophosphat (GaPO₄) ist.

12. AOFW-Elemente nach Anspruch 10, insbesonders für den Einsatz bei erhöhten Temperaturen von 300°C und mehr, **dadurch gekennzeichnet, dass** das piezoelektrische Substrat aus einer piezoelektrischen Metallnitridschicht mit III-V-Verbindungshalbleitercharakter, insbesondere AlN und GaN, gebildet ist, die ihrerseits auf ein nicht-piezoelektrisches Substrat aufgewachsen ist.

## Claims

1. A high temperature-resistant, electrically conductive thin film suitable for use at increased temperatures of more than 300 °C, having a thickness of ≤ 1 µm for application to a solid substrate, **characterised in that** the thin film consists of a mixture of two complementary components, an electrically conductive material (conductive metal) with a melting point > 1500 °C, and an aluminium oxide component formed from aluminium-rich aluminium oxides in the form of aluminium-rich non-stoichiometric oxides or aluminium (III) oxide/aluminium mixtures as a structuring agent for the conductive metal.

2. The high temperature-resistant, electrically conductive thin film according to Claim 1, **characterised in that** the conductive metal consists of platinum, palladium, molybdenum, chromium, titanium, tantalum, tungsten, iridium, rhodium, or alloys of these elements.

3. The high temperature-resistant, electrically conductive thin film according to claim 2, **characterised in that** the proportion of the conductive metal of the entire thin film is at least 50 % (v/v), preferably 60 % (v/v) to 80 % (v/v).

4. A method for producing temperature-resistant, electrically conductive thin films according to one of Claims 1 to 3, **characterised in that** the conductive metal and the aluminium oxide component are applied to a surface alternately in the form of thin conductive metal and aluminium oxide films of a corresponding composition, each preferably 5 nm to 20 nm thick, until the desired film thickness ≤ 1 µm is achieved, and **in that** these deposited films are subjected prior to use to a tempering step lasting a number of hours at typically 600 °C or more, whereby the individual films mix, such that a mixture of aluminium oxide component and conductive metal is formed.

5. A method for producing temperature-resistant, electrically conductive thin films according to one of Claims 1 to 3, **characterised in that** the conductive metal and the aluminium oxide component are applied to a surface simultaneously, in particular by simultaneous vapour deposition or sputtering of the conductive metal and of the metallic aluminium in an oxidising reactive gas atmosphere.

6. The method for producing temperature-resistant, electrically conductive thin films according to Claim 4 or 5, **characterised in that**, before and/or after the deposition of the electrically conductive thin film, adhesive layers, diffusion barriers and/or cover layers are additionally applied to the substrate and/or the electrically conductive thin film(s).

7. A high temperature-resistant element comprising a substrate and an electrically conductive thin film according to one of Claims 1 to 3 applied thereto.

8. The high temperature-resistant element according to Claim 7, **characterised in that** an adhesive layer and/or diffusion barrier, preferably based on aluminium oxide, is/are present between the substrate and the electrically conductive thin film.

9. The high temperature-resistant element according to Claim 7 or 8, **characterised in that** at least one passivating cover layer covering the electrically conductive thin film and/or the substrate and preferably based on aluminium oxide is present.

10. Surface acoustic wave (SAW) elements, in particular for use at elevated temperatures of 300 °C and more, comprising a piezoelectric substrate and an electrically conductive thin film according to one of Claims 1 to 3 applied thereto.

11. SAW elements according to Claim 10, in particular for use at elevated temperatures of 300 °C and more, **characterised in that** the piezoelectric substrate is selected from the group:
- thermally stable materials from the LGX family, in particular langasite (La₃Ga₅SiO₁₄), langanite (La₃Ga_{5.5}Nb_{0.5}O₁₄) or langanate (La₃Ga_{5.5}Ta_{0.5}O₁₄), or substitution isomorphs thereof, such as La₃Ga_{5.25}Ta_{0.25}Si_{0.5}O₁₄ or La₃Ga₅Zr_{0.5}Si_{0.5}O₁₄), or
- structurally isomorphic compounds of the general composition A₃BC₃Si₂O₁₄, such as Sr₃TaGa₃Si₂O₁₄, Sr₃NbGa₃Si₂O₁₄, Ca₃TaGa₃Si₂O₁₄ or Ca₃TaAl₃Si₂O₁₄, or
- lanthanoid-calcium oxyborates, in particular GdCa₄O(BO₃)₃, YCa₄O(BO₃)₃ or LaCa₄O(BO₃)₃, or
- lithium niobates (LiNbOₓ, x≈3), or
- gallium-orthophosphate (GaPO₄).

12. SAW elements according to Claim 10, in particular for use at elevated temperatures of 300 °C and more, **characterised in that** the piezoelectric substrate is formed from a piezoelectric metal nitride film with a III-V compound semiconductor nature, in particular AlN and GaN, which is in turn grown on a non-piezoelectric substrate.

## Revendications

1. Couche mince conductrice d'électricité, résistant à des ultrahautes températures, destinée à être utilisée à des températures élevées supérieures à 300 °C, d'une épaisseur ≤ 1 µm, pour l'application sur un substrat solide, **caractérisée en ce que** la couche mince est constituée d'un mélange de deux composants complémentaires, d'une matière conductrice d'électricité (métal conducteur) avec un point de fusion < 1500 °C et d'un composant en oxyde d'aluminium en oxydes riches en aluminium sous la forme d'oxydes d'aluminium non stoechiométriques, riches en aluminium ou d'oxyde de (III)aluminium/ de mélanges d'aluminium, en tant que structurant pour le métal conducteur.

2. Couche mince conductrice d'électricité, résistant à des ultrahautes températures selon la revendication 1, **caractérisée en ce que** le métal conducteur est constitué de platine, de palladium, de molybdène, de chrome, de titane, de tantale, de tungstène, d'iridium, de rhodium ou d'alliages desdits éléments.

3. Couche mince conductrice d'électricité, résistant à des ultrahautes températures selon la revendication 2, **caractérisée en ce que** la part en métal conducteur dans l'ensemble de la couche mince se situe à au moins 50 % (v/v), de préférence à de 60 % (v/v) à 80 % (v/v).

4. Procédé destiné à la fabrication d'une couche mince conductrice d'électricité, résistant à des ultrahautes températures selon l'une quelconque des revendications 1 à 3, **caractérisée en ce qu'**on applique le métal conducteur et le composant en oxyde d'aluminium sur une surface, alternativement sous le forme de couches minces de métal conducteur et d'oxyde d'aluminium de composition correspondante, de préférence d'une épaisseur de 5 nm à 20 nm chacune, jusqu'à l'obtention de l'épaisseur de couche ≤ 1 µm souhaitée et **en ce qu'**avant l'utilisation, on soumet lesdites couches déposées à une étape de recuit de plusieurs heures, à une température type de 600 °C ou supérieure, ce qui provoque un mélange des couches, de sorte à créer un mélange de composant d'oxyde d'aluminium et de métal conducteur.

5. Procédé destiné à la fabrication d'une couche mince conductrice d'électricité, résistant à des ultrahautes températures selon l'une quelconque des revendications 1 à 3, **caractérisé en ce qu'**on applique simultanément le métal conducteur et le composant d'oxyde d'aluminium sur une surface, notamment par métallisation sous vide ou pulvérisation cathodique simultanée du métal conducteur et de l'aluminium métallique sous une atmosphère de gaz réactif oxydant.

6. Procédé destiné à la fabrication d'une couche mince conductrice d'électricité, résistant à des ultrahautes températures selon la revendication 4 ou la revendication 5, **caractérisé en ce qu'**on applique en supplément sur le substrat et/ou sur la (les) couche(s) minces(s) conductrice(s) d'électricité (avant et/ou après avoir déposé la couche mince conductrice d'électricité) des couches adhésives, des barrières de diffusion et/ou des couches de recouvrement.

7. Elément résistant à des ultrahautes températures, comprenant un substrat, ainsi qu'une couche mince conductrice d'électricité selon l'une quelconque des revendications 1 à 3 appliquée sur celui-ci.

8. Elément résistant à des ultrahautes températures selon la revendication 7, **caractérisé en ce qu'**entre le substrat et la couche conductrice d'électricité se trouve une couche adhésive et/ou une barrière de diffusion, de préférence sur base d'aluminium.

9. Elément résistant à des ultrahautes températures selon la revendication 7 ou la revendication 8, **caractérisé par** la présence d'au moins une couche de recouvrement de passivation, de préférence sur base d'oxyde d'aluminium qui recouvre la couche mince conductrice d'électricité et/ou le substrat.

10. Eléments à ondes acoustiques superficielles, notamment destinés à être utilisés à des températures élevées de 300 °C et supérieures, comprenant un substrat piézoélectrique et une couche mince conductrice d'électricité selon l'une quelconque des revendications 1 à 3, appliquée sur ce dernier.

11. Eléments à ondes acoustiques superficielles selon la revendication 10, notamment destinés à être utilisés à des températures élevées de 300 °C et supérieures, **caractérisés en ce que** le substrat piézoélectrique est choisi dans le groupe comprenant :
- des matières thermiquement stables, de la famille des LGX (famille dite des langasites), notamment la langasite (LA₃GaₛSiO₁₄) , la langanite (La₃Ga₅Nb₀O₁₄) ou la langanate (La₃Ga_{5.5}Ta_{0.5}O₁₄) ou leurs substitutions isomorphes, telles que par exemple la La₃Ga_{5.25}Ta_{0.25}Si_{0.5}O₁₄ ou la La₃Ga₅Zr_{0.5}Si_{0.5}O₁₄ ou
- des composants à structure isomorphe par rapport à ces derniers, de la composition générale A₃BC₃Si₂O₁₄, comme par exemple Sr₃TaGa₃Si₂O₁₄, Sr₃NbGa₃Si₂O₁₄, Ca₃TaGa₃Si₂O₁₄ ou Ca₃TaAl₃Si₂O₄ ou
- des oxyborates de calcium-lanthanide, notamment le GdCa₄O(BO₃)₃, le Yca4ₒ(BO₃)₃ ou le Laca₄O(BO₃)₃ ou
- des niobates de lithium (LinBoₓ, x=3) ou
- l'ortophosphate de Gallium (GaPO₄).

12. Eléments à ondes acoustiques superficielles selon la revendication 10, notamment destinés à être utilisés à des températures élevées de 300 °C et supérieures, **caractérisés en ce que** le substrat piézoélectrique est formé d'une couche de nitrure métallique piézoélectrique à caractère de semiconducteur à composés III-V, notamment en ALn et en GaN, quant à elle épitaxiée sur substrat non piézoélectrique.
